Europäisches Patentamt

European Patent Office

Office européen des brevets

(19)

(11) Veröffentlichungsnummer: **0 315 000 B1**

(12) **EUROPÄISCHE PATENTSCHRIFT**

(45) Veröffentlichungstag der Patentschrift: **27.12.91**

(21) Anmeldenummer: **88117629.1**

(22) Anmeldetag: **22.10.88**

Teilanmeldung 91103311.6 eingereicht am 22/10/88.

(51) Int. Cl.⁵: **B23K 1/08**, B23K 1/00, //H05K3/34

(54) **Lötvorrichtung.**

(30) Priorität: **05.11.87 DE 3737563**

(43) Veröffentlichungstag der Anmeldung: **10.05.89 Patentblatt 89/19**

(45) Bekanntmachung des Hinweises auf die Patenterteilung: **27.12.91 Patentblatt 91/52**

(84) Benannte Vertragsstaaten: **AT BE CH DE ES FR GB GR IT LI LU NL SE**

(56) Entgegenhaltungen:
**DE-U- 8 520 254**

**PATENT ABSTRACTS OF JAPAN vol. 9, no. 14 (M-352)(1737) 22 Januar 1985, & JP-A-59 163071 (HITACHI SEISAKUSHO K.K.)**

(73) Patentinhaber: **Hohnerlein, Ernst**
**Ringstrasse 7**
**W-6983 Kreuzwertheim(DE)**

(72) Erfinder: **Hohnerlein, Ernst**
**Ringstrasse 7**
**W-6983 Kreuzwertheim(DE)**

(74) Vertreter: **Schieferdecker, Lutz, Dipl.-Ing.**
**Herrnstrasse 37**
**W-6050 Offenbach am Main(DE)**

**Beschreibung**

Die Erfindung betrifft eine Lötvorrichtung, insbesondere zum Herstellen von Lötverbindungen auf der Rückseite einer elektronische Bauteile tragenden gedruckten Leiterplatte, mit einem eine Lötkammer umschließenden mittleren Löttunnel zwischen einem Eintrittstunnel und einem Austrittstunnel, einer Fördervorrichtung für den Transport der mit den Lötverbindungen zu versehenden Werkstücke durch den Einstrittstunnel, den Löttunnel und den Austrittstunnel, wobei die Förderstrecke innerhalb der Lötkammer in Förderrichtung ansteigt, einer in der Lötkammer mündenden Leitung für ein Schutzgas, vorzugsweise Stickstoff, einer Wanne für ein Lötmittel-Schmelzbad, die unterhalb der Förderstrecke im Bereich der Lötkammer angeordnet und mit einer Heizeinrichtung sowie wenigstens einer Umwälzpumpe versehen ist, und wenigstens einer Lötdüse innerhalb der Lötkammer mit aufwärts gerichteter Düsenöffnung zur Erzeugung eines mit den über die Düsenöffnung hinweg bewegten Werkstücken in Kontakt tretenden Schwalls aus dem umgewälzten Lötmittel.

Eine derartige Lötvorrichtung mit einer Schutzgasatmosphäre in der Lötkammer ist bereits bekannt (DE-U1-85 20 254). Durch das Schutzgas wird Luftsauerstoff von der Lötstelle ferngehalten, wodurch die Lötqualität erheblich gesteigert werden kann, weil Luftsauerstoff zu einer Versprödung der Oberflächen der Lötstellen führen würde. Des weiteren ermöglicht die infolge der hintereinander angeordneten Tunnel langgestreckte Vorrichtung eine hohe Lötleistung, weil sämtliche an der schräg abwärts weisenden Rückseite von Leiterplatten auszubildende Lötverbindungen beim Passieren des Lötmittelschwalls ausgebildet werden, wobei der Umstand ausgenutzt wird, daß sich das Lot nur an den durch die Leiterplatte zu ihrer Rückseite geführten metallischen Leitern ansetzt.

Bei der bekannten Lötvorrichtung wird als Schutzgas Stickstoff verwendet, dem jedoch Wasserstoff zugesetzt ist. Diese Wasserstoff wirkt reduzierend und kann trotz der Schutzgasatmosphäre in der Lötkammer noch vorhandenen Sauerstoff binden. Am Eintrittsende und am Austrittsende der Tunnelanordnung besteht jedoch die Gefahr, daß es infolge einer Vermischung mit Luft zu einem explosiven Gemisch kommt. Deswegen sind an den Enden der Tunnelanordnung Schleusen vorgesehen, deren Schleusenkammer nach jedem Schleusenvorgang durch Absaugung von Luft bzw. Schutzgas geleert wird. Dadurch wird die Vorrichtung jedoch kompliziert, wobei auch die Leistung vergleichsweise gering ist, weil das Durchschleusen der Werkstücke keinen kontinuierlichen Betrieb der Fördervorrichtung mit dem Lötvorgang angepaßter hoher Geschwindigkeit ermöglicht.

Ein weiterer Nachteil der bekannten Vorrichtung besteht darin, daß der Löttunnel in seinem mittleren Bereich eine Gehäuseerweiterung mit einer vergleichsweise großen Lötkammer aufweist, die auch die Wanne für das Schmelzbad aufnimmt. Diese Gehäuseerweiterung widerspricht nicht nur einer kompakten Bauweise sondern führt auch zu einem vergleichsweise großen Lötkammervolumen und damit Schutzgasvolumen. Des weiteren herrscht in der Lötkammer eine vergleichsweise hohe Temperatur, da das schmelzflüssige Lötmittel bei circa 250° C aufgebracht wird. Dementsprechend sind alle der Wanne für das Schmelzbad zugeordneten und innerhalb der Lötkammer angeordneten Bauteile wie insbesondere auch die Antriebe für die Umwälzung des Lötmittels und ggf. die Höheneinstellung der Wanne mit der Lötdüse diesen hohen Temperaturen ausgesetzt, was sich ungünstig auswirkt.

Die Erfindung liegt die Aufgabe zugrunde, die Lötvorrichtung einfacher, leistungsfähiger und besser anpaßbar an die jeweiligen vom Werkstück her bestehenden Erfordernisse zu machen, ohne daß negative Einwirkungen durch Luftsauerstoff und eine dadurch bedingte Einbuße an Lötqualität in Kauf genommen werden müssen.

Diese Aufgabe wird erfindungsgemäss dadurch gelöst, dass der Löttunnel mit der in der Lötkammer angeordneten Förderstrecke zur Veränderung der Förderstreckenneigung um eine horizontale Querachse verschwenkbar ist, daß die Wanne mit dem Lötmittel-Schmelzbad unterhalb des Bodens der Lötkammer angeordnet ist, der Boden der Lötkammer eine Bodenöffnung aufweist, die Lötdüse mit ihrem Versorgungskanal aus der Wanne durch die Bodenöffnung in die Lötkammer aufragt und der Tunnelboden mit einer die Bodenöffnung umschließenden Dichtungsschürze versehen ist, die in die Wanne herabragt und in das Schmelzbad eintaucht.

Bei dieser Ausbildung ist die Lötkammer vollständig in den Löttunnel integriert, der keine Gehäuseerweiterung aufweist und mit einem im wesentlichen unveränderten Tunnelquerschnitt ausgeführt sein kann, der vorzugsweise demjenigen des Eintrittstunnels und des Austrittstunnels entspricht. Somit ergibt sich eine vergleichsweise kleine Lötkammer, deren Füllmenge an Schutzgas entsprechend gering ist. Die Schmelzbadwanne ist außerhalb der Lötkammer angeordnet, wobei der Anschluß an die Lötkammer durch die Bodenöffnung und die Dichtungsschütze hergestellt ist, die aus Edelstahl hergestellt sein kann und eine problemlose sichere Abdichtung gegen das Eindringen von Luft in die Lötkammer bildet. Bei dieser Anordnung der Wanne außerhalb der Lötkammer und der vorgesehenen Tauchabdichtung durch die Dichtungsschütze können Relativbewegungen zwischen der Wanne und dem Löttunnel problemlos vorgenommen werden, wobei entsprechende Bauteile wie auch der Antriebsmotor der Umwälzpumpe für das schmelzflüssige Lötmittel keinen oder doch nur geringen Temperaturbelastungen ausgesetzt sind. Bei Verwendung eines neutralen Schutzgases wie Stickstoff können auch aufwendige Schleusenvorrichtungen an den Enden der Tunnelanordnung entfallen, insbesondere wenn eine lange Tunnelanordnung gewählt wird und das Schutzgas mit geringem Überdruck in die Lötkammer eingeleitet wird. So kann die Lötkammer bzw. die Lötzone absolut luftfrei gehalten werden.

Die bereits hervorgehobene Möglichkeit der Relativbewegung zwischen der Schmelzbad-Wanne und dem Löttunnel kann dadurch ausgenutzt werden, daß der Löttunnel mit der in der Lötkammer angeordneten Förderstrecke zur Veränderung der Förderstreckenneigung um eine horizontale Querachse verschwenkbar ist. Unterschiedliche Anstiegswinkel der Fördervorrichtung mit entsprechend veränderter Neigung der mit dem Lötmittelschwall in Kontakt tretenden Leiterplatten-Unterseite führen zu differenziertem Lötverhalten und ermöglichen eine einfache Anpassung an die jeweiligen Verhältnisse. Dabei führt ein steilerer Winkel zu weniger Lotauftrag, während ein flacherer Winkel mehr Lotauftrag bedeutet. Im übrigen ist die Neigung des Löttunnels auch für das Fernhalten von Luftsauerstoff von Bedeutung. Die Luft ist schwerer als das Schutzgas (Stickstoff), so daß eingedrungene Luft sich an den tieferliegenden Stellen der Tunnelanordnung ansammelt. Dieser Umstand läßt sich auch durch eine geneigte Anordnung des Eintrittstunnels und des Austrittstunnels nutzten.

Entsprechende Ausgestaltungen sowie andere vorteilhafte Weiterbildungen ergeben sich aus den Unteransprüchen.

Ein Ausführungsbeispiel der Erfindung wird anhand einer schematischen Zeichnung nachfolgend näher erläutert. Es zeigen:

Fig. 1     eine teilweise geschnittene Seitenansicht der Lötvorrichtung;

Fig. 2     eine Draufsicht auf die Lötvorrichtung gemäß Fig. 1;

Fig. 3     einen vergrößerten Ausschnitt aus Fig. 1;

Fig. 4     einen Schnitt längs Linie IV-IV in Fig. 1 und

Fig. 5     ein Wechselaggregat für die Reduktionsmittelzufuhr in Seitenansicht.

Die Lötvorrichtung weist ein in den Figuren nicht dargestelltes Maschinengestell, Antriebe und Versorgungseinrichtungen auf, die grundsätzlich bekannt sind. Als wesentliches Bauteil weist die Vorrichtung eine langgestreckte Tunnelanordnung 1 auf, die einen Eintrittstunnel 2, einen Löttunnel 3 und einen Austrittstunnel 4 umfaßt. Der Eintrittstunnel 2 ist in zwei Tunnelabschnitte 5 und 6 unterteilt, von denen der Tunnelabschnitt 5 den Eingangsabschnitt bildet. Die Tunnelabschnitte 5 und 6 sind ebenso wie die Tunnel 2, 3 und 4 durch biegsame Bälge 7, 8 und 9 miteinander verbunden.

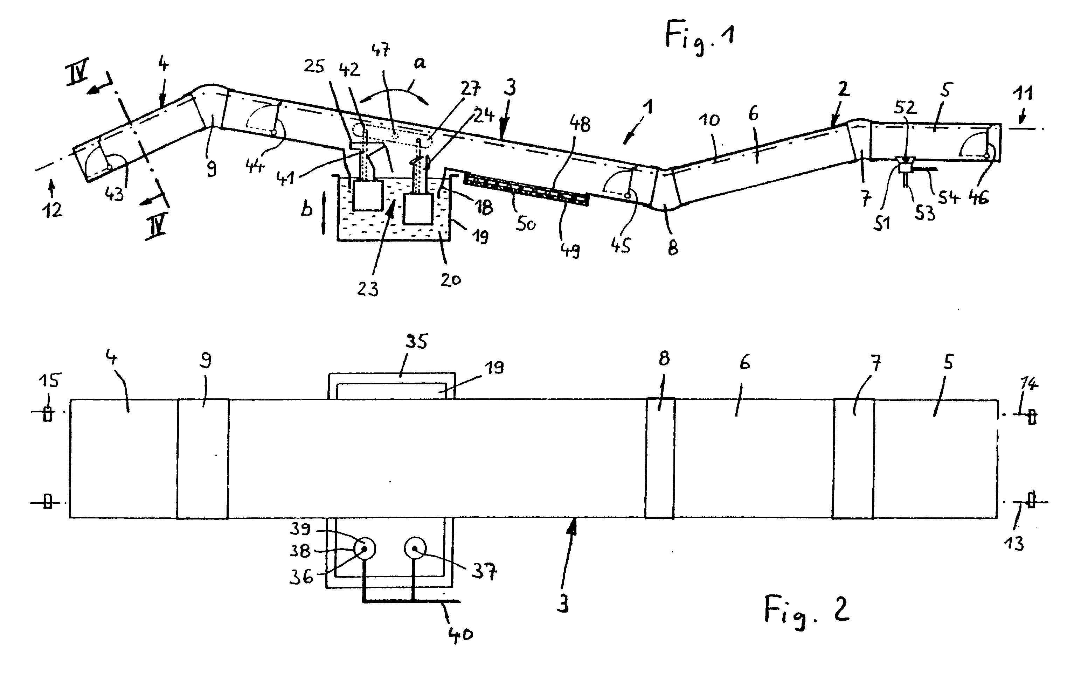

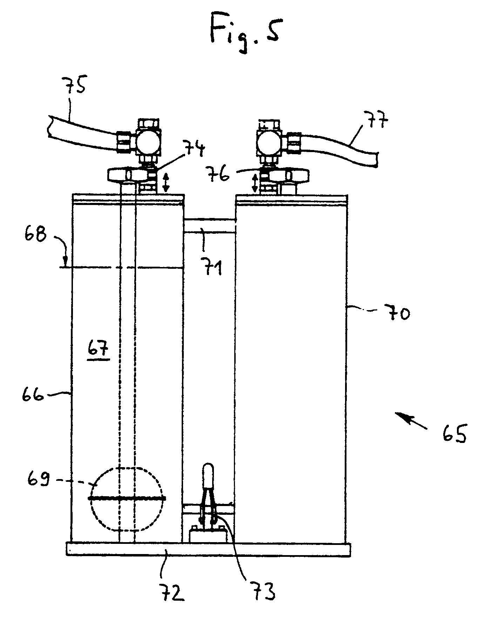

Durch die Tunnelanordnung erstreckt sich eine Fördervorrichtung 10, die in Fig. 1 nur strichpunktiert mit der Förderbahn angedeutet ist. Die Fördervorrichtung 10 erstreckt sich an beiden Enden über die Tunnelanordnung 1 hinaus und bildet dabei eine Beschickungsstation 11 und eine Entnahmestation 12 zum Einhängen bzw. zum Entnehmen der Werkstücke wie Leiterplatten, an denen Lötungen vorgenommen werden sollen. Entsprechend der Durchlaufrichtung der Werkstücke in Fig. 1 von rechts nach links sind der Tunnelabschnitt 5 im wesentlichen horizontal, der Tunnelabschnitt 6 in Förderrichtung fallend, der Löttunnel 3 in Förderrichtung ansteigend und der Austrittstunnel 4 in Förderrichtung wieder fallend angeordnet. Die Fördervorrichtung 10 erstreckt sich in entsprechender Weise längs einer abgewinkelten Bahn. Wie Fig. 2 zeigt weist die Fördervorrichtung 10 zwei parallele seitliche Fördertrume 13 und 14 auf, an denen aufeinander ausgerichtete Halterungen 15 angeordnet sind, mit denen die Werkstücke bzw. Leiterplatten an gegenüberliegenden Seiten festgeklemmt werden können, so daß sie an der Fördervorrichtung 10 aufgehängt sind und mit dieser durch die Tunnelanordnung 1 transportiert werden. Diese weist auf ihrer ganzen Länge einen im wesentlichen rechteckigen Querschnitt von vergleichsweise geringer Höhe auf, wie es Fig. 4 zeigt.

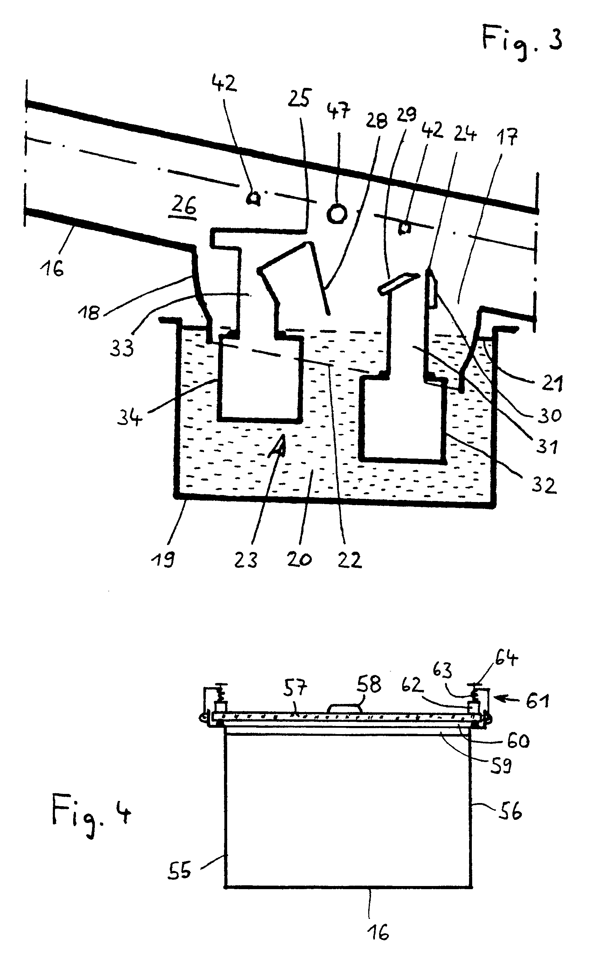

Wie insbesondere aus Fig. 3 zu ersehen weist der Tunnelboden 16 des Löttunnels 3 in einem mittleren Längenbereich eine Bodenöffnung 17 auf, die von einer herabragenden Dichtungsschürze 18 umgeben ist. Unterhalb der Bodenöffnung 17 ist eine Wanne 19 angeordnet, die mit einer nicht dargestellten Heizeinrichtung versehen ist und das Schmelzbad aus dem verflüssigten Lötmittel 20 aufnimmt. Wie dargestellt taucht die Dichtungsschürze 18 durch den Badspiegel 21 hindurch in das verflüssigte Lötmittel 20 ein, so daß der untere Schürzenrand 22 vollständig unterhalb des Badspiegels 21 angeordnet ist.

Zum Aufbringen des Lots auf die schräg abwärts weisende Unterseite der Werkstücke ist eine Löteinrichtung 23 mit wenigstens einer Lötdüse vorgesehen. Beim dargestellten Ausführungsbeispiel sind zwei Lötdüsen 24 und 25 vorhanden, die einen sich horizontal und quer zum Löttunnel 3 erstreckenden Düsenschlitz aufweisen. Die Lötdüsen 24 und 25 sind von unterschiedlicher Ausbildung und Ausrichtung, wobei die Lötdüse 24 als Auftragsdüse und die in Transportrichtung nachfolgende Lötdüse 25 als Abstreifdüse wirkt. Die Düsen 24 und 25 sind innerhalb der vom Löttunnel 3 umschlossenen Lötkammer 26 oberhalb des Badspiegels 21 angeordnet. Sie bestimmen die in Fig. 1 eingezeichnete Lötzone oder Lötstrecke 27. Während die Lötdüse 25 ein zum Badspiegel 21 hin geneigtes Ablaufblech 28 aufweist, ist die Lötdüse 24 mit Leitblechen 29 und 30 versehen. Die Lötdüse 24 ist über einen durch den Badspiegel 21 ragenden Steigkanal 31 mit einem sich innerhalb der Wanne 19 in Querrichtung erstreckenden Versorgungskanal 32 verbunden. In entsprechender Weise sind der Lötdüse 25 ein Steigkanal 33 und ein Versorgungskanal 34 zugeordnet.

Wie aus Fig. 2 zu ersehen erstreckt sich die innerhalb eines Isoliermantels 35 angeordnete Wanne 19 quer zum Löttunnel 3 und ragt im wesentlichen auf einer Seite über diesen vor. Dort ist jedem Versorgungskanal 32 und 34 eine eigene Umwälzpumpe zugeordnet, deren Betrieb dazu führt, daß aus beiden Lötdüsen 24 und 25 jeweils ein Schwall des flüssigen Lötmittels austritt, der mit der Unterseite der durch die Fördervorrichtung 10 vorbei transportierten Werkstücke in Kontakt tritt. In Fig. 2 sind von diesen Pumpen nur die beiden Antriebswellen 36 und 37 zu sehen, die sich senkrecht durch den Badspiegel 21 erstrecken, an ihrem oberen Ende mit einem Antriebsmotor versehen sind und an ihrem unteren Ende ein Pumprad tragen. Jede Antriebswelle 36 und 37 ist mit einem umgekehrt becherförmigen Topf 38 versehen, dessen nach oben weisender Topfboden 39 gasdicht von der Antriebswelle 36 bzw.37 durchdrungen ist und dessen herabragender zylindrischer Rand wie die Dichtungsschürze 18 in das flüssige Lötmittel 20 eintaucht. Über eine Stickstoffleitung 40 werden beide Töpfe 38 mit Stickstoff versorgt, so daß sich in ihnen keine Luft und damit kein Sauerstoff mehr befindet. Auf diese Weise wird verhindert, daß Luft entlang de Antriebswellen 36 und 37 in das Lötmittel 20 eindringt und zu den Lötdüsen 24 bzw. 25 gepumpt wird. Außerdem wird dem in Gegenwart von Sauerstoff stark korrodierenden Angriff des heißflüssigen Lötmittels 20 auf die Antriebswellen vorgebeugt.

Zwei weitere Schutzgasleitungen 41, durch die Stickstoff unter geringem Überdruck durch Austrittsöffnungen 42 (Fig. 3) in die Lötkammer 26 ausströmt, sind in Fig. 1 angedeutet. Der zugeführte Stickstoff füllt die gesamte Tunnelanordnung 1 einschließlich des von der Dichtungsschürze 18 umschlossenen Raums oberhalb des Badspiegels 21 und verhindert somit den Zutritt von Luft zur Lötstrecke 27. Um dem Ausströmen von Stickstoff aus der Tunnelanordnung und einer Vermischung mit Luft vorzubeugen, sind wie in Fig. 1 angedeutet vier den Tunnelquerschnitt im wesentlichen verschließende Dichtungsklappen 43, 44, 45 und 46 vorgesehen, die von passierenden Werkstücken bzw. der Fördervorrichtung 10 in Transportrichtung aufgeklappt werden und sich danach wieder schließen. Mit den vorstehend beschriebenen Maßnahmen gelingt es, den Sauerstoffanteil im Bereich der Lötstrecke 27 unter 3 ppm zu halten, was für eine hohe Lötqualität wesentlich ist.

Der Löttunnel 3 ist mittels einer nicht dargestellten Verstellvorrichtung um eine horizontale Querachse 47 schwenkbar, wie dieses in Fig. 1 durch den Doppelbogenpfeil a angedeutet ist. Auf diese Weise kann die Neigung des Löttunnels 3 und damit auch die Schrägstellung der durch den Löttunnel 3 transportierten Werkstücke den jeweiligen Gegebenheiten angepaßt werden. Die Neigungsänderung ist problemlos durchführbar, weil die Bälge 7, 8 und 9 Stellungsveränderungen der Tunnelanordnung 1 aufnehmen und weil die in das flüssige Lötmittel 20 eintauchende Dichtungsschürze Gewähr dafür bietet, daß trotz einer Relativbewegung zwischen dem Löttunnel 3 und der Wanne 19 keine Luft in die Lötkammer 26 eindringt. Aus diesem Grunde ist auch eine einfache Höhenverstellung der Wanne 19 mittels einer nicht dargestellten Verstelleinrichtung entsprechend dem Doppelpfeil b in Fig. 1 möglich, wodurch die Lötdüsen 24 und 25 in eine gegenüber der Transportbahn der Fördervorrichtung 10 bzw. gegenüber den passierenden Werkstücken zweckmäßige Stellung gebracht werden können.

Wie aus Fig. 1 zu ersehen ist im Tunnelboden 16 des Löttunnels 3 in Transportrichtung vor der Dichtungsschürze 18 eine Glaskeramikplatte 48 eingebaut, an deren Unterseite elektrische Heizstäbe 49 angeordnet sind, die nach unten durch eine Isolierung 50 abgeschirmt sind. Mittels der Heizstäbe 49 werden die durch den Löttunnel 3 vorbewegten Werkstücke soweit vorgewärmt, daß Beschädigungen durch eine plötzliche Temperaturerhöhung im Bereich der Lötstrecke 27 vermieden werden.

Zum Aufbringen eines Flußmittels auf die Unterseiten der Werkstücke ist im Boden des Tunnelabschnitts 5 gemäß Fig. 1 eine Sprüheinrichtung 51 mit einer Ultraschall-Zerstäuberdüse 52 angeordnet. Diese Sprüheinrichtung ist in der gleichzeitig unter der Bezeichnung "Verfahren und Vorrichtung zum Auftragen eines Flußmittels" eingereichten Patentanmeldung näher beschrieben. Die Ultraschall-Zerstäuberdüse 52 zerstäubt über eine Speiseleitung 53 im wesentlichen drucklos zugeführtes Flußmittel, das üblicherweise natürliche oder modifizierte Harze mit Zusätzen einschließlich einer Säure enthält und reduzierend auf die zu verlötenden Metalloberflächen einwirkt. Es ist vorgesehen, anstelle des bisher schaumförmig aufgebrachten und zu starken Verschmierungen der Vorrichtung führenden Flußmittels reine Adipinsäure ohne Zusätze aufzubringen, das als Pulver mit 1 % in Äthylalkohol gelöst in dünnflüssiger Form durch die Ultraschall-Zerstäuberdüse 52 vernebelt wird und durch einen den Nebel ringförmig umschließenden Luftstrom gezielt auf die Werkstückunterseite aufgebracht wird. Dazu ist an die Sprüheinrichtung 51 eine Druckluftleitung 54 angeschlossen.

Die aus Fig. 4 zu ersehende Tunnelausbildung gilt im wesentlichen unverändert für die gesamte Tunnelanordnung 1 bzw. die Tunnel 2, 3 und 4. Danach weist der bzw. jeder Tunnel einen Boden 16 und zwei von diesem aufragende Tunnelwände 55 und 56 auf, die vorzugsweise aus Leichtmetall bestehen. Die Tunneloberseite wird im wesentlichen von einer Reihe von abnehmbaren Sichtglasplatten 57 gebildet, die eine handliche Länge in Erstreckungsrichtung der Tunnelanordnung 1 aufweisen und an ihren Schmalseiten mit einem Griff 58 versehen sind. An der Stoßstelle zwischen benachbarten Sichtglasplatten sind die Tunnelwände 55 und 56 durch Querstege 59 miteinander verbunden, die zusammen mit den oberen Randbereichen der Tunnelwände 55 und 56 eine umlaufende Auflagefläche bilden, an welche die Sichtglasplatte 57 unter Zwischenfügung eines geschlossenen Dichtstreifens 60 abdichtend angedrückt ist. Dazu sind auf beiden Tunnelseiten in Abständen Schnellarretierungen verschwenkbar am oberen Rand der Tunnelwand 55 bzw. 56 angelenkt. Jede Schnellarretierung 61 weist ein Druckstück 62 auf, das in der dargestellten Betriebsstellung mittels einer Feder 63 die Sichtglasplatte 57 gegen den Dichtstreifen 60 drückt. Durch einen Lösegriff 64 kann das Druckstück entgegen der Federkraft hochgezogen und die Schnellarretierung 61 seitlich weggeschwenkt werden. Als Sichtglasplatten 57 sind Platten aus Sicherheitsglas (Drahtglas) vorgesehen. Im Bereich der Lötstrecke 27 und auch im Bereich der Heizstäbe 49 sind Sichtglasplatten aus temperaturbeständiger Glaskeramik vorgesehen. Diese Maßnahmen ermöglichen eine optische Kontrolle längs der gesamten Tunnelanordnung 1 und insbesondere auch im Bereich der Lötstrecke 27 sowie erforderlichenfalls einen schnellen Zugang an jeder Stelle der Tunnelanordnung 1 durch Entfernen der betreffenden Sichtglasplatte 57. Die einzelnen Sichtglasplatten 57 und Schnellarretierungen 61 sind in den Figuren 1 und 2 nicht dargestellt.

Trotz der weitgehenden Sicherheit, mit der durch die vorbeschriebenen Maßnahmen Luft und damit Luftsauerstoff von der Lötstrecke 27 ferngehalten wird, kann vorsorglich dem Schutzgas (Stickstoff) noch ein Reduktionsmittel zugesetzt werden. Zweckmäßigerweise wird dazu eine exakt dosierbare Teilmenge des der Lötkammer 26 über die Schutzgasleitung 41 zugeführten Stickstoffs abgezweigt und mit reduzierend wirkender Ameisensäure in gasförmiger Form beladen. Eine dafür verwendbare Anreicherungseinrichtung 65 ist in Fig.5 dargestellt. Die Anreicherungseinrichtung 65, die an grundsätzlich beliebiger Stelle der Vorrichtung angeordnet werden kann, weist einen Reduziermittelbehälter 66 mit einer Nachfüllkammer 67 für die flüssige Ameisensäure auf, deren maximaler Füllstand mit 68 angedeutet ist. Eine Schwimmerkugel 69 signalisiert das Erreichen des minimalen Füllstandes und damit die Notwendigkeit zum Behälterwechsel bzw. zum Nachfüllen von Ameisensäure. Dem Reduziermittelbehälter 66 ist ein Tropfenabscheidebehälter 70 zugeordnet. Die Behälter 66 und 70 sind durch eine Überströmleitung 71 verbunden und durch eine Halterung 72 zu einem Aggregat verbunden, das mittels eines Schnellverschlusses 73 montiert und gelöst wird, um gegen ein entsprechendes nachgefülltes Aggregat ausgetauscht zu werden. Das kann bei kurzzeitiger Abschaltung der Stickstoffzufuhr ohne Unterbrechung des Lötbetriebs geschehen. Dazu sind noch die Schnellvrscheraubung 74 zwischen der Stickstoffzuleitung 75 und dem Reduziermittelbehälter 66 sowie die Schnellverschraubung 76 zwischen dem Tropfenabscheidebehälter 70 und der Stickstoffableitung 77 zu lösen und nach dem Aggregatwechsel wieder anzuschrauben. Es hat sich gezeigt, daß ein Durchströmen der Anreicherungseinrichtung 65 mit einem geringen Stickstoffdurchsatz von beispielsweise 5 l/min genügt, um eine ausreichende Menge an gasförmig aufgenommener Ameisensäure der Lötkammer 26 zuzuführen.

Bezugszeichenliste

| 1 | Tunnelanordnung |
|---|---|
| 2 | Eintrittstunnel |
| 3 | Löttunnel |
| 4 | Austrittstunnel |
| 5 | Tunnelabschnitt |
| 6 | Tunnelabschnitt |
| 7 | Balg |
| 8 | Balg |
| 9 | Balg |
| 10 | Fördervorrichtung |
| 11 | Beschickungsstation |
| 12 | Entnahmestation |
| 13 | Fördertrum |
| 14 | Fördertrum |
| 15 | Halterung |
| 16 | Tunnelboden |
| 17 | Bodenöffnung |
| 18 | Dichtungsschürze |
| 19 | Wanne |
| 20 | Lötmittel, Schmelzbad |
| 21 | Badspiegel |
| 22 | Schürzenrand |
| 23 | Löteinrichtung |
| 24 | Lötdüse |
| 25 | Lötdüse |
| 26 | Lötkammer |

27 Lötstrecke
28 Ablaufblech
29 Leitblech
30 Leitblech
31 Steigkanal
32 Versorgungskanal
33 Steigkanal
34 Versorgungskanal
35 Isoliermantel
36 Antriebswelle
37 Antriebswelle
38 Topf
39 Topfboden
40 Stickstoffleitung
41 Schutzgasleitung
42 Austrittstöffnung
43 Dichtungsklappe
44 Dichtungsklappe
45 Dichtungsklappe
46 Dichtungsklappe
47 Querachse
48 Glaskeramikplatte
49 Heizstab
50 Isolierung
51 Sprüheinrichtung
52 Ultraschall-Zerstäuberdüse
53 Speiseleitung
54 Druckluftleitung
55 Tunnelwand
56 Tunnelwand
57 Sichtglasplatte
58 Griff
59 Quersteg
60 Dichtstreifen
61 Schnellarretierung
62 Druckstück
63 Feder
64 Lösegriff
65 Anreicherungseinrichtung
66 Reduziermittelbehälter
67 Nachfüllkammer
68 maximaler Füllstand
69 Schwimmerkugel
70 Tropfenabscheidebehälter
71 Überströmleitung
72 Halterung
73 Schnellverschluß
74 Schnellverschraubung
75 Stickstoffzuleitung
76 Schnellverschraubung
77 Stickstoffableitung

**Patentansprüche**

1. Lötvorrichtung insbesondere zum Herstellen von Lötververbindungen auf der Rückseite einer elektronische Bauteile tragenden gedruckten Leiterplatte mit

- einem eine Lötkammer (26) umschließenden mittleren Löttunnel (3) zwischen einem Eintrittstunnel (2) und einem Austrittstunnel (4),
- einer Fördervorrichtung (10) für den Transport der mit den Lötverbindungen zu versehenden Werstücke durch den Eintrittstunnel (2), den Löttunnel (3) und den Austrittstunnel (4), wobei die Förderstrecke innerhalb der Lötkammer in Förderrichtung ansteigt,
- einer in der Lötkammer (26) mündenden Leitung (41) für ein Schutzgas, vorzugsweise Stickstoff,
- einer Wanne (19) für ein Lötmittel-Schmelzbad (20) die unterhalb der Förderstrecke im Bereich der Lötkammer (26) angeordnet und mit einer Heizeinrichtung sowie wenigstens einer Umwälzpumpe versehen ist, und
- wenigstens einer Lötdüse (24,25) innerhalb der Lötkammer (26) mit aufwärts gerichteter Düsenöffnung zur Erzeugung eines mit den über die Düsenöffnung hinweg bewegten Werkstücken in Kontakt tretenden Schwalls aus dem umgewälzten Lötmittel, dadurch **gekennzeichnet, daß**

- der Löttunnel (3) mit der in der Lötkammer (26) angeordneten Förderstrecke zur Veränderung der Förderstreckenneigung um eine horizontale Querachse (47) verschwenkbar ist,
- die Wanne (19) mit dem Lötmittel-Schmelzbad unter halb des Bodens (16) der Lötkammer (26) angeordnet ist,
- der Boden (16) der Lötkammer (26) eine Bodenöffnung (17) aufweist,
- die Lötdüse (24,25) mit ihrem Versorgungskanal (31, 32; 33,34) aus der Wanne (19) durch die Bodenöffnung (17) in die Lötkammer (26) aufragt und
- der Boden (16) mit einer die Bodenöffnung (17) umschließenden Dichtungsschürze (18) versehen ist, die in die Wanne (19) herabragt und in das Schmelzbad (20) eintaucht.

2. Lötvorrichtung nach Anspruch 1, dadurch gekennzeichnet, daß der die Bodenöffnung (17) aufweisende Löttunnel (3) flach ist.

3. Lötvorrichtung nach Anspruch 1, dadurch gekennzeichnet, daß der die Bodenöffnung (17) aufweisende Löttunnel (3) in Förderrichtung ansteigt.

4. Lötvorrichtung nach Anspruch 1 bis 3, dadurch gekennzeichnet, daß der an den Löttunnel (3) anschließende Austrittstunnel (4) in Förderrichtung fallend angeordnet ist.

5. Lötvorrichtung nach einem der Ansprüche 1 bis 4, dadurch gekennzeichnet, daß der Eintrittstunnel (2) entgegengesetzt zum mit der ansteigenden Förderstrecke ansteigenden Löttunnel (3) fallend angeordnet ist.

6. Lötvorrichtung nach einem der Ansprüche 1 bis 5, dadurch gekennzeichnet, daß der Eintrittstunnel (2) zwei - in senkrechter Richtung - zueinander abgewinkelte Tunnelabschnitte (5,6) aufweist, wobei der Eingangsabschnitt (5) im wesentlichen horizontal verläuft.

7. Lötvorrichtung nach einem der Ansprüche 1 bis 6, dadurch gekennzeichnet, daß die Tunnel (2,3,4) und die gegebenenfalls vorgesehenen Tunnelabschnitte (5,6) durch gasdichte biegsame Bälge (7,8,9) miteinander verbunden sind.

8. Lötvorrichtung nach einem der Ansprüche 1 bis 7, dadurch gekennzeichnet, daß die Antriebswelle (36,37) der Umwälzpumpe außerhalb der Schürze (18) in das Schmelzbad (20) eintaucht und von einem koaxialen, nach unten offenen, becherförmigen Topf (38) umgeben ist, dessen Boden (39) gasdicht mit der Antriebswelle (36,37) verbunden ist und dessen Wand in das Schmelzbad (20) eintaucht, und daß auch in diesen Topf (38) eine Leitung (40) für Schutzgas mündet.

9. Lötvorrichtung nach einem der Ansprüche 1 bis 8, dadurch gekennzeichnet, daß die Wanne (19) mit der Lötdüse (24,25) gegenüber dem Löttunnel (3) höhenverstellbar ist.

10. Lötvorrichtung nach einem der Ansprüche 1 bis 9, dadurch gekennzeichnet, daß ein Bereich des Löttunnelbodens (16) in Transportrichtung vor der Schürze (18) von einer Glaskeramikplatte (48) gebildet ist, unter der eine Heizstab-Anordnung (49) vorgesehen ist.

11. Lötvorrichtung nach einem der Ansprüche 1 bis 10, dadurch gekennzeichnet, daß im Tunnelboden (16) in Transportrichtung vor der Schürze (18), vorzugsweise im Boden (16) des Eintrittstunnels (2), eine Auftragseinrichtung (51) zum Aufbringen eines Flußmittels auf die von der Fördervorrichtung (10) vorbewegten Werkstücke angeordnet ist.

12. Lötvorrichtung nach einem der Ansprüche 1 bis 11, dadurch gekennzeichnet, daß die Oberseiten der Tunnel (2,3,4) im wesentlichen von abnehmbaren Sichtglasplatten (57) gebildet sind, die über geschlossene Dichtstreifen (60) an die sich gegenüberliegenden Tunnelwände (55,56) und an diese verbindende obere Querstege (59) angedrückt sind.

13. Lötvorrichtung nach Anspruch 12, dadurch gekennzeichnet, daß dem Löttunnel (3) Sichtglasplatten (57) aus Glaskeramik zugeordnet sind und im übrigen die Sichtglasplatten (57) aus Sicherheitsglas bestehen.

14. Lötvorrichtung nach einem der Ansprüche 1 bis 13, dadurch gekennzeichnet, daß der Schutzgasleitung (41) eine wenigstens von einem Anteil des zugeführten Schutzgases durchströmte Anreicherungseinrichtung (65) für die Zuführung eines Reduziermittels, vorzugsweise Ameisensäure, zur Lötkammer (26) zugeordnet ist.

15. Lötvorrichtung nach Anspruch 14, dadurch gekennzeichnet, daß die Anreicherungseinrichtung (65) ein leicht einsetzbares und entnehmbares Wechselaggregat (66,70) mit einer Nachfüllkammer (67) für das Reduziermittel und einer Abscheidekammer für Reduziermitteltropfen aufweist, die nacheinander vom Schutzgas durchströmt werden.

**Claims**

1. A soldering apparatus, in particular for producing solder connections on the back of a printed circuit board carrying electronic components, comprising:
   - a middle soldering tunnel (3) between an entry tunnel (2) and an exit tunnel (4), the middle soldering tunnel (3) enclosing a soldering chamber (26),
   - a conveyor device (10) for transportation of the workpieces to be provided with the solder connections through the entry tunnel (2), the soldering tunnel (3) and the exit tunnel (4), the conveyor section rising within the soldering chamber in the conveying direction,
   - a conduit (41) which opens in the soldering chamber (26) for a protective gas, preferably nitrogen,
   - a vat (19) for a molten soldering agent bath (20), which is disposed beneath the conveyor section in the region of the soldering chamber (26) and is provided with a heating means and at least one circulating pump, and

- at least one soldering nozzle (24, 25) within the soldering chamber (26) with an upwardly directed nozzle opening for producing a surge from the circulated soldering agent, which surge comes into contact with the workpieces which are moved over the nozzle opening, characterised in that
- the soldering tunnel (3) with the conveyor section arranged in the soldering chamber (26) is pivotable about a horizontal transverse axis (47) for varying the inclination of the conveyor section,
- the vat (19) with the molten soldering agent bath is disposed beneath the bottom (16) of the soldering chamber (26),
- the bottom (16) of the soldering chamber (26) has a bottom opening (17),
- the soldering nozzle (24, 25) projects with its supply passage (31, 32; 33, 34) out of the vat (19) through the bottom opening (17) into the soldering chamber (26), and
- the bottom (16) is provided with a sealing skirt (18) which extends around the bottom opening (17), extends down into the vat (19) and dips into the molten bath (20).

2. A soldering apparatus according to claim 1 characterised in that the soldering tunnel (3) which has the bottom opening (17) is flat.

3. A soldering apparatus according to claim 1 characterised in that the soldering tunnel (3) which has the bottom opening (17) rises in the conveying direction.

4. A soldering apparatus according to claims 1 to 3 characterised in that the exit tunnel (4) adjoining the soldering tunnel (3) is arranged to fall in the conveying direction.

5. A soldering apparatus according to one of claims 1 to 4 characterised in that the entry tunnel (2) is arranged to fall in opposite relationship to the soldering tunnel (3) which rises with the rising conveyor section.

6. A soldering apparatus according to one of claims 1 to 5 characterised in that the entry tunnel (2) has two tunnel portions (5, 6) which are angled relative to each other in a vertical direction, the intake portion (5) extending substantially horizontally.

7. A soldering apparatus according to one of claims 1 to 6 characterised in that the tunnels (2, 3, 4) and the optionally provided tunnel portions (5, 6) are connected together by gastight flexible bellows (7, 8, 9).

8. A soldering apparatus according to one of claims 1 to 7 characterised in that the drive shaft (36, 37) of the circulating pump dips into the molten bath (20) outside the skirt (18) and is surrounded by a coaxial, downwardly open, cup-shaped pot (38), the bottom (39) of which is gas-tightly connected to the drive shaft (36, 37) and the wall of which dips into the molten bath (20), and that a conduit (40) for protective gas also opens into said pot (38).

9. A soldering apparatus according to one of claims 1 to 8 characterised in that the vat (19) is adjustable in respect of height, with the soldering nozzle (24, 25), relative to the soldering tunnel (3).

10. A soldering apparatus according to one of claims 1 to 9 characterised in that a region of the bottom (16) of the soldering tunnel, upstream of the apron (18) in the transportation direction, is formed by a glass ceramic panel (48), beneath which is disposed a heating bar arrangement (49).

11. A soldering apparatus according to one of claims 1 to 10 characterised in that disposed in the bottom (16), upstream of the apron (18) in the transportation direction, and preferably in the bottom (16) of the entry tunnel (2), is an applicator means (51) for applying a fluxing agent to the workpieces which are advanced by the conveyor device (10).

12. A soldering apparatus according to one of claims 1 to 11 characterised in that the top sides of the tunnels (2, 3, 4) are essentially formed by removable sight glass panels (57) which are pressed by way of closed sealing strips (60) against the mutually oppositely disposed tunnel walls (55, 56) and against upper transverse limb portions (59) connecting same.

13. A soldering apparatus according to claim 12 characterised in that sight glass panels (57) of glass ceramic are associated with the soldering tunnel (3) and elsewhere the sight glass panels (57) comprise safety glass.

14. A soldering apparatus according to one of claims 1 to 13 characterised in that associated with the protective gas conduit (41) is an enrichment means (65) through which flows at least a portion of the protective gas supplied, for the supply of a reducing agent, preferably formic acid, to the soldering chamber (26).

15. A soldering apparatus according to claim 14 characterised in that the enrichment means (65) has an easily insertable and removable interchange unit (66, 70) with a refilling chamber (67) for the reducing agent and a separating chamber for reducing agent drops, the protective gas flowing successively therethrough.

**Revendications**

1. Dispositif de soudage, notamment pour réaliser des liaisons brasées sur le côté arrière d'une plaquette à circuits imprimés supportant des composants électroniques, comprenant:
   - un tunnel de brasage central (3) entourant une chambre de brasage (26) entre un tunnel d'entrée (2) et un tunnel de sortie (4),
   - un dispositif transporteur (10) pour le transport des pièces à munir des liaisons brasées par le tunnel d'entrée (2), le tunnel de brasage (3) et le tunnel de sortie (4), le parcours d'alimentation montant à l'intérieur de la chambre de brasage dans la direction de l'avance,
   - une conduite (41) débouchant dans la chambre de brasage (26) pour le gaz protecteur, de préférence de l'azote,
   - une cuvette (19) pour un bain d'agent de brasage en fusion (20) disposée au-dessous du parcours d'alimentation dans la région de la chambre de brasage (26) et munie d'un dispositif de chauffage ainsi que d'au moins une pompe de circulation, et
   - au moins une buse de brasage (24, 25) à l'intérieur de la chambre de brasage (26) comprenant une ouverture de buse dirigée vers le haut pour déterminer un jet d'agent de brasage venant en contact avec les pièces qui sont déplacées au-dessus de l'ouverture de buse,
      caractérisé en ce que
      le tunnel de brasage (3) peut être pivoté avec le parcours d'alimentation prévu dans la chambre de brasage (26) pour modifier l'inclinaison du parcours d'alimentation par rapport à un axe transversal horizontal (47),
   - la cuvette (19) est disposée avec le bain d'agent de brasage en fusion au-dessous du fond (16) de la chambre de brasage (26),
   - le fond (16) de la chambre de brasage (26) comprend une ouverture de fond (17),
   - la buse de brasage (24, 25) fait saillie avec son canal d'alimentation (31, 32; 33, 34) de la cuvette (19) pour parvenir dans la chambre de brasage (26) par l'ouverture de fond (17), et
   - le fond (16) est muni d'une jupe d'étanchéité qui entoure l'ouverture de fond (17) et qui fait saillie dans la cuvette (19) et plonge dans le bain en fusion (20).

2. Dispositif de soudage selon la revendication 1, caractérisé en ce que le tunnel de brasage (3) comprenant l'ouverture de fond (17) est plat.

3. Dispositif de soudage selon la revendication 1, caractérisé en ce que le tunnel de brasage (3) comprenant l'ouverture de fond (17) est incliné vers le haut dans la direction de l'avance.

4. Dispositif de soudage selon les revendications 1 à 3, caractérisé en ce que le tunnel de sortie (4) qui est raccordé au tunnel de brasage (3) va en descendant dans le sens de l'avance.

5. Dispositif de soudage selon l'une des revendications 1 à 4, caractérisé en ce que le tunnel d'entrée (2) va en descendant et en sens contraire au tunnel de brasage qui monte (3) avec le parcours d'alimentation montant.

6. Dispositif de soudage selon l'une des revendications 1 à 5, caractérisé en ce que le tunnel d'entrée (2) comprend deux sections de tunnel (5, 6) formant un angle - en direction verticale - l'une par rapport à l'autre, la section d'entrée (5) étant sensiblement horizontale.

7. Dispositif de soudage selon l'une des revendications 1 à 6, caractérisé en ce que le tunnel (2, 3, 4) et les sections de tunnel éventuellement prévues (5, 6) sont reliées les unes aux autres par des soufflets (7, 8, 9) souples et étanches aux gaz.

8. Dispositif de soudage selon l'une des revendications 1 à 7, caractérisé en ce que l'arbre d'entraînement (36, 37) de la pompe de circulation plonge à l'extérieur de la jupe (18) dans le bain en fusion (20) et est entouré d'un pot en forme de godet (38) coaxial et ouvert vers le bas, dont le fond (39) est relié de façon étanche aux gaz à l'arbre d'entraînement (36, 37) et dont la paroi plonge dans le bain en fusion (20), en ce qu'une conduite (40) destinée aux gaz de protection débouche également dans ce pot (38).

9.  Dispositif de soudage selon l'une des revendications 1 à 8, caractérisé en ce que la cuvette (19) peut être réglée en hauteur avec la buse de brasage (24, 25) par rapport au tunnel de brasage (3).

10. Dispositif de soudage selon l'une des revendications 1 à 9, caractérisé en ce qu'une région du fond (16) du tunnel de brasage est constituée dans la direction du transport et avant la jupe (18) par une plaque en céramique de verre (48) au-dessous de laquelle est prévu un agencement à cartouche chauffante (49).

11. Dispositif de soudage selon l'une des revendications 1 à 10, caractérisé en ce qu'il est prévu dans le fond (16) et en direction du dispositif de transport, à l'avant de la jupe (18), et de préférence dans le fond (16) du tunnel d'entrée (2), un dispositif d'application (51) pour diriger un flux sur les pièces qui sont avancées par le dispositif transporteur (10).

12. Dispositif de soudage selon l'une des revendications 1 à 11, caractérisé en ce que les côtés supérieurs du tunnel (2, 3, 4) sont constitués essentiellement par des plaques en verre transparentes (57) pouvant être enlevées, qui sont pressées sur des bandes d'étanchéité fermées (60) sur les parois opposées (55, 56) du tunnel et sur leurs branches transversales supérieures (59) qui les relient.

13. Dispositif de soudage selon la revendication 12, caractérisé en ce que des plaques de verre transparentes (57) en céramique de verre sont associées au tunnel de brasage (3) et en ce qu'en outre les plaques de verre transparentes (57) sont constituées par du verre de sécurité.

14. Dispositif de soudage selon l'une des revendications 1 à 13, caractérisé en ce qu'à la conduite à gaz de protection (41) est associé un dispositif d'enrichissement (65) traversé par au moins une partie du gaz de protection qui est alimenté, en vue de l'amenée d'un agent réducteur dans la chambre de brasage (26), qui est de préférence de l'acide formique.

15. Dispositif de soudage selon la revendication 14, caractérisé en ce que le dispositif d'enrichissement (65) comprend un ensemble remplaçable (66, 70) facile à mettre en place et à retirer, comprenant une chambre de remplissage (67) pour l'agent réducteur et une chambre de dépôt pour les gouttes d'agent réducteur, qui sont traversées l'une après l'autre par le gaz de protection.

Fig. 1

Fig. 2

EP 0 315 000 B1

Fig. 3

Fig. 4

Fig. 5